(19) Europäisches Patentamt / European Patent Office / Office européen des brevets

(11) **EP 3 124 437 A1**

(12) **EUROPEAN PATENT APPLICATION**
published in accordance with Art. 153(4) EPC

(43) Date of publication:
01.02.2017 Bulletin 2017/05

(51) Int Cl.:
*C01G 23/04* (2006.01)　*C08K 3/00* (2006.01)
*C08K 3/28* (2006.01)　*C08L 63/00* (2006.01)
*H01L 23/29* (2006.01)　*H01L 23/31* (2006.01)

(21) Application number: 15769951.3

(22) Date of filing: 23.03.2015

(86) International application number:
PCT/JP2015/058695

(87) International publication number:
WO 2015/146892 (01.10.2015 Gazette 2015/39)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA

(30) Priority: 27.03.2014　JP 2014064922

(71) Applicant: Mitsubishi Materials Electronic Chemicals Co.,
Ltd.
Akita-shi
Akita 010-8585 (JP)

(72) Inventors:
• KAGEYAMA, Kensuke
Akita-shi
Akita 010-8585 (JP)
• ISHIKURO, Shigeki
Akita-shi
Akita 010-8585 (JP)

(74) Representative: Gille Hrabal
Brucknerstrasse 20
40593 Düsseldorf (DE)

(54) **BLACK TITANIUM OXYNITRIDE PIGMENT, METHOD FOR PRODUCING SAME, AND SEMICONDUCTOR-SEALING RESIN COMPOUND USING BLACK TITANIUM OXYNITRIDE PIGMENT**

(57) In the present invention, the amount of a radiation emitted by a black titanium oxynitride pigment is 0.1 cph/cm$^2$ or less. In addition, it is preferable for the black titanium oxynitride pigment to have a uranium content of 1 ppb by mass or less and a thorium content of 5 ppb by mass or less.

**EP 3 124 437 A1**

**Description**

TECHNICAL FIELD

The present invention relates to a black titanium oxynitride pigment decreased in a uranium content and a thorium content, a method of producing the black titanium oxynitride pigment, and a semiconductor-sealing resin compound using the black titanium oxynitride pigment. The present International Application claims a priority of Japanese Patent Application No. 064922 (patent application No. 2014-064922) filed on March 27, 2014 and the whole contents of Japanese Patent Application No. 2014-064922 are incorporated herein by reference.

BACKGROUND ART

It has heretofore been disclosed a carbon black colorant for a semiconductor sealing material, which has a residue on a sieve with a pore size of 25 $\mu$m of 0% by weight and a residue on a filter paper of the quantitative filter paper No. 5A of 0.5 ppm or less and which has been obtained by subjecting carbon black to wet oxidation treatment, passing through a filter having a pore size of 5 $\mu$m or less, and then, spray-drying a carbon black slurry which had been concentrated and adjusted the carbon black content to 3 to 50% by mass (for example, see Patent Document 1.). In the carbon black colorant thus constituted, large-sized aggregates have been removed, so that a semiconductor-sealing resin composition using the colorant is suppressed to cause electric failure by short-circuiting between the wirings due to the aggregates by being sandwiched the aggregates of the carbon black between wirings. Also, in the highly integrating semiconductor devices, it is excellent in fluidity, moldability and laser marking property of the resin composition, so that it is suitable for sealing a semiconductor device such as IC and LSI.

PRIOR ART REFERENCES

PATENT DOCUMENTS

Patent Document 1: JP 2005-206621A (claim 1, Paragraph [0019])
Patent Document 2: JP Hei.9-137269A (Paragraph [0015])

SUMMARY OF THE INVENTION

PROBLEMS TO BE SOLVED BY THE INVENTION

The conventional carbon black for a semiconductor sealing material disclosed in the above-mentioned Patent Document 1 has, however, conductivity inherently, so that if a wiring pitch of the semiconductor device becomes narrower as 30 $\mu$m or less, in the sealing material using the above-mentioned carbon black as a filler, there is a fear that the wiring is short-circuited due to the aggregates of the carbon black being sandwiched between the wirings. To solve the above point, to have electric insulation of the filler itself is required, and as the filler satisfying the requirement, i.e., the filler excellent in electric insulation, there is a black titanium oxynitride pigment (a titanium black pigment) . However, in the black titanium oxynitride pigment, there is a risk of generating $\alpha$ radiation caused by impurities (in particular, lead) contained in ilmenite ore (a starting material of titanium oxide which becomes a starting material of black titanium oxynitride). When a white titanium oxide pigment is produced by using the ilmenite ore and a black titanium oxynitride pigment is then produced, and a semiconductor device is sealed by a sealing material using the black titanium oxynitride pigment as a filler, if $\alpha$ radiation is generated from the black titanium oxynitride pigment, there is a fear of causing the so-called soft error of the semiconductor device by the $\alpha$ radiation. More specifically, it has been known when the amount of emitted $\alpha$ radiation exceeds 0.1 cph/cm$^2$, soft error which is malfunction of the semiconductor device by the $\alpha$ radiation occurs (for example, see Patent Document 2.).

An object of the present invention is to provide a black titanium oxynitride pigment, which does not short-circuit the wirings even when a wiring pitch of the semiconductor device, etc. , is narrow, and can suppress occurrence of soft error which is malfunction of the semiconductor device, etc. , by $\alpha$ radiation, when it is used as a filler of a resin compound for sealing the semiconductor device, etc., a method of producing the same and a semiconductor-sealing resin compound using the black titanium oxynitride pigment.

MEANS FOR SOLVING THE PROBLEMS

The first aspect of the present invention is a black titanium oxynitride pigment with an amount of emitted $\alpha$ radiation of 0.1 cph/cm$^2$ or less.

The second aspect of the present invention is an invention based on the first aspect, wherein it further comprises a uranium content of 1 ppb by mass or less, and a thorium content of 5 ppb by mass or less.

The third aspect of the present invention is an invention based on the first or the second aspect, wherein it further comprises a lightness index L* value in CIE 1976 L*a*b* color space (light source C for measurement: color temperature 6774K) of 14 or less.

The fourth aspect of the present invention is an invention based on any of the first to third aspects, wherein it further comprises a BET specific surface area of 10 m$^2$/g or more.

The fifth aspect of the present invention is an invention based on any of the first to fourth aspects, wherein it further comprises an average primary particle size of 15 nm to 140 nm.

The sixth aspect of the present invention is a method of producing a black titanium oxynitride pigment which comprises a step of distilling titanium chloride to decrease a uranium content and a thorium content in the titanium chloride to 10 ppb by mass or less and 50 ppb by mass or less, respectively, a step of reacting the distilled titanium chloride with an alcohol to form titanium alkoxide, a step of distilling the titanium alkoxide to decrease a uranium content and a thorium content in the titanium alkoxide to 1 ppb by mass or less and 5 ppb by mass or less, respectively, a step of hydrolyzing the distilled titanium alkoxide to form a white titanium oxide pigment, and a step of reducing the white titanium oxide pigment with an ammonia gas to obtain a black titanium oxynitride pigment having a uranium content and a thorium content of 1 ppb by mass or less and 5 ppb by mass or less, respectively.

The seventh aspect of the present invention is a semiconductor-sealing resin compound which comprises the black titanium oxynitride pigment defined in any of the first to the fifth aspects being dispersed in a mixture of an epoxy resin, a curing agent, a curing accelerator and an inorganic filler.

EFFECTS OF THE INVENTION

In the black titanium oxynitride pigment of the first aspect of the present invention, the amount of emitted $\alpha$ radiation is a little as 0.1 cph/cm$^2$ or less, so that when a resin compound in which the black titanium oxynitride pigment has been dispersed is used as a sealing material for a semiconductor device, etc., occurrence of soft error which is malfunction of a semiconductor device, etc., by $\alpha$ radiation can be suppressed as described in Patent Document 2.

In the black titanium oxynitride pigment of the second aspect of the present invention, the uranium content in the black titanium oxynitride pigment is 1 ppb by mass or less, and the thorium content is 5 ppb by mass or less, so that the black titanium oxynitride pigment has high electric insulation and high shielding property of the $\alpha$ radiation. As a result, when the black titanium oxynitride pigment is used as a filler of a resin compound for sealing a semiconductor device, etc., even when the wiring pitch of the semiconductor device, etc., is narrow, the black titanium oxynitride pigment as the filler does not short-circuit the wirings, and occurrence of soft error which is malfunction of the semiconductor device, etc., by the $\alpha$ radiation can be suppressed.

In the black titanium oxynitride pigment of the third aspect of the present invention, the lightness index L* value of the black titanium oxynitride pigment in the CIE 1976 L*a*b* color space (light source C for measurement: color temperature 6774K) is made 14 or less, so that insufficiency of blackness of the black titanium oxynitride pigment can be prevented. As a result, when the above-mentioned black titanium oxynitride pigment is used as a filler of the semiconductor-sealing resin compound, concealing property of the semiconductor device, etc., by the sealing material can be improved.

In the black titanium oxynitride pigment of the fourth aspect of the present invention, the BET specific surface area of the black titanium oxynitride pigment is 10 m$^2$/g or more, so that tinting strength (coloring strength) can be made good.

In the black titanium oxynitride pigment of the fifth aspect of the present invention, the average primary particle size of the black titanium oxynitride pigment is 15 nm to 140 nm, so that occurrence of aggregations can be suppressed and lowering in tinting strength (coloring strength) can be prevented.

In the method of producing the black titanium oxynitride pigment of the sixth aspect of the present invention, titanium chloride is distilled to decrease both of a uranium content and a thorium content in the titanium chloride, thereafter the distilled titanium chloride is reacted with an alcohol to prepare titanium alkoxide, then, the titanium alkoxide is distilled to decrease both of a uranium content and a thorium content in the titanium alkoxide, next, the distilled titanium alkoxide is hydrolyzed to form a white titanium oxide pigment, and further the white titanium oxide pigment is reduced by an ammonia gas to produce a black titanium oxynitride pigment, so that both of electric insulation and shielding property of the $\alpha$ radiation of the black titanium oxynitride pigment become high. As a result, when the above-mentioned black titanium oxynitride pigment is used as a filler of a resin compound for sealing the semiconductor device, etc., even when the wiring pitch of the semiconductor device, etc., is narrow, the black titanium oxynitride pigment as the filler does not short-circuit the wirings, and occurrence of soft error which is malfunction of the semiconductor device, etc., by the $\alpha$ radiation can be suppressed.

In the semiconductor-sealing resin compound of the seventh aspect of the present invention, the black titanium oxynitride pigment contained in the semiconductor-sealing resin compound has high electric insulation and high shielding property of the $\alpha$ radiation, so that when the resin compound is used as a sealing material of the semiconductor device, etc. , even when the wiring pitch of the semiconductor device, etc., is narrow, the black titanium oxynitride pigment in the sealing material does not short-circuit the wirings, and occurrence of soft error which is malfunction of the semiconductor device, etc., by the $\alpha$ radiation can be suppressed.

EMBODIMENTS OF THE INVENTION

Next, embodiments to carry out the present invention are explained. The black titanium oxynitride pigment has the amount of emitted $\alpha$ radiation of 0.1 cph/cm$^2$ or less. In addition, the black titanium oxynitride pigment preferably has a uranium content of 1 ppb by mass or less and a thorium content of 5 ppb by mass or less. Here, in the black titanium oxynitride pigment, the reasons why the uranium content is limited to 1 ppb by mass or less and the thorium content is limited to 5 ppb by mass or less are that if the uranium content exceeds 1 ppb by mass and the thorium content exceeds 5 ppb by mass, the amount of emitted $\alpha$ radiation exceeds 0.1 cph/cm$^2$, there is a fear of causing soft error which is malfunction of the semiconductor device, etc., by the $\alpha$ radiation. Further, the above-mentioned black titanium oxynitride pigment is represented by the chemical formula : $TiN_XO_Y$ provided that X=0.2 to 1.4 and Y=0.1 to 1.8, and shows a black color. Here, in the above-mentioned chemical formula: $TiN_XO_Y$, the reason why X is limited to the range of 0.2 to 1.4 is that if it is less than 0.2, a degree of reduction is low so that blackness is insufficient, while if it exceeds 1.4, it reveals yellowish so that predetermined color tone as the black pigment cannot be obtained. In addition, in the above-mentioned chemical formula: $TiN_XO_Y$, the reason why Y is limited to the range of 0.1 to 1.8 is that if it is out of the range, predetermined color tone as the black pigment cannot be obtained. Incidentally, the mass ratio of oxygen and nitrogen (O/N) in the above-mentioned chemical formula: $TiN_XO_Y$ is preferably in the range of 0.2 to 6.

On the other hand, the lightness index L* value in the CIE 1976 L*a*b* color space (light source C for measurement: color temperature 6774K) of the black titanium oxynitride pigment is 14 or less, preferably 7 to 11. The above-mentioned CIE 1976 L*a*b* color space is a color space defined by the International Commission on Illumination (CIE) and changed in 1976 in which CIE XYZ color system has been changed that a constant distance in the color system has a substantially equivalent difference perceptually even in any of the color regions. Also, the lightness index L* value, the a* value and the b* value are amounts determined by the orthogonal coordinate system in the CIE 1976 L*a*b* color space, and represented by the following formula (1) to the formula (3).

$$L^* = 116 (Y/Y_0)^{1/3} - 16 \qquad \qquad \cdots\cdots (1)$$

$$a_* = 500 [ (X/X_0)^{1/3} - (Y/Y_0)^{1/3} ] \qquad \cdots\cdots (2)$$

$$b^* = 200 [ (Y/Y_0)^{1/3} - (Z/Z_0)^{1/3} ] \qquad \cdots\cdots (3)$$

Provided that $X/X_0$, $Y/Y_0$ and $Z/Z_0 > 0.008856$, and X, Y and Z are tristimulus values of object color. Also, $X_0$, $Y_0$ and $Z_0$ are tristimulus values of light sources which illuminate object color, and normalized to $Y_0 = 100$. Further, the lightness index L* value of the black titanium oxynitride pigment is obtained by using, for example, a spectrophotometer (Type: SE2000) manufactured by NIPPON DENSHOKU INDUSTRIES Co., LTD. Here, the reason why the lightness index L* value of the black titanium oxynitride pigment is limited to 14 or less is that if it exceeds 14, blackness is insufficient so that predetermined color tone as the black pigment cannot be obtained.

On the other hand, the BET specific surface area of the black titanium oxynitride pigment is preferably 10 m$^2$/g or more, more preferably 120 m$^2$/g or less. The above-mentioned BET specific surface area can be obtained by, for example, adsorbing gas molecules (for example, a nitrogen gas, etc.) of which the adsorption occupied area had been known onto the surface of the black titanium oxynitride pigment, measuring the adsorption amount by using a specific surface area measurement device (Type: SA1100) manufactured by SIBATA SCIENTIFIC TECHNOLOGY, LTD., and calculating therefrom. Provided that, to the information of the gas molecules adsorbed onto the surface of the black titanium oxynitride pigment in the course of transferring from the adsorption at the first layer to the multi-layer adsorption, by applying the formula of BET (the formula showing the relation between an adsorption equilibrium pressure and an adsorption amount at the pressure when it is in an adsorption equilibrium state at a constant temperature), an amount of the gas molecules at one layer alone can be measured, whereby an accurate specific surface area can be measured. Here, the reason why the preferred range of the BET specific surface area of the black titanium oxynitride pigment is limited to 10 m²/g or more is that if it is less than 10 m²/g, tinting strength (coloring strength) is lowered. Further, the reason why the more preferred range of the BET specific surface area of the black titanium oxynitride pigment is limited to 120 m²/g or less is that if it exceeds 120 m²/g, tinting strength (coloring strength) is inferior and aggregation is likely caused.

On the other hand, an average primary particle size of the black titanium oxynitride pigment is preferably in the range of 15 nm to 140 nm, more preferably in the range of 20 nm to 90 nm. The average primary particle size of the above-mentioned black oxynitride pigment is a particle size measured by using a transmission type electron microscope (TEM), and is a volume-based average primary particle size. Here, the reason why the preferred range of the average primary particle size of black titanium oxynitride pigment is limited to 15 nm to 140 nm is that if it is less than 15 nm, the particles are too fine and aggregation occurs in some cases, and tinting strength (coloring strength) is likely insufficient, while if it exceeds 140 nm, the particles are too large and tinting strength (coloring strength) is lowered in some cases.

The method of producing the black titanium oxynitride pigment thus constituted is explained. First, titanium chloride is treated by a method of decreasing impurities to decrease a uranium content and a thorium content in the titanium chloride to 10 ppb by mass or less and 50 ppb by mass or less, respectively. Here, the method of decreasing impurities of the titanium chloride may be mentioned the distillation method, the method of using activated carbon, or the method of using the distillation method and the method of using activated carbon in combination, etc. Then, the above-mentioned distilled titanium chloride is reacted with an alcohol to form titanium alkoxide. Here, the alcohol may be mentioned isopropanol, ethanol, butanol, etc. When isopropanol is used as the alcohol, titanium tetraisopropoxide is formed, when ethanol is used as the alcohol, titanium ethoxide is formed, and butanol is used as the alcohol, titanium butoxide is formed. And the above-mentioned titanium alkoxide is distilled to decrease a uranium content and a thorium content in the titanium alkoxide to 1 ppb by mass or less and 5 ppb by mass or less, respectively. Here, the distillation method of the titanium alkoxide may be mentioned the normal-pressure distillation method, the reduced-pressure distillation method, etc., and in the present invention, the reduced-pressure distillation method is used. Next, the above-mentioned distilled titanium alkoxide is hydrolyzed to form a white titanium oxide pigment ($TiO_2$). Here, water alone may be used at the time of hydrolysis, but an acid or an alkali may be added to water as a catalyst. Further, the above-mentioned white titanium oxide pigment ($TiO_2$) is reduced by an ammonia gas to obtain a black titanium oxynitride pigment. More specifically, the white titanium oxide pigment ($TiO_2$) is reduced by an ammonia gas to obtain a black titanium oxynitride pigment in which a uranium content and a thorium content are 1 ppb by mass or less and 5 ppb by mass or less, respectively. The black titanium oxynitride pigment is represented by the chemical formula: $TiN_XO_Y$ (provided that X=0.2 to 1.4 and Y=0.1 to 1.8). A reduction ratio of the above-mentioned white titanium oxide pigment ($TiO_2$) can be controlled by raising a reaction temperature, increasing a flow amount of the ammonia gas or elongating a reaction time, and if the reduction ratio is high, blackness of the black titanium oxynitride pigment is improved. That is, the L* value becomes low. The black titanium oxynitride pigment is wet-pulverized to obtain a dispersion of the black titanium oxynitride pigment. This wet-pulverization is carried out by pulverizing the black titanium oxynitride pigment dispersed in an alcohol by a bead mill until an average primary particle size thereof becomes in the range of 15 nm to 140 nm. Further, the dispersion is separated into the solid and the liquid, and the solid is dried to obtain a black titanium oxynitride pigment in a powder state.

Next, the method of producing the semiconductor-sealing resin compound by using the thus produced black titanium oxynitride pigment is explained. First an epoxy resin, a curing agent, a curing accelerator and an inorganic filler are mixed to prepare a mixture. The epoxy resin is preferably a polyfunctional type epoxy resin, and specific examples thereof may be mentioned a biphenyl type epoxy resin, a glycidyl amine type epoxy resin, a triphenyl glycidyl methane type epoxy resin, a tetraphenyl glycidyl methane type epoxy resin, an aminophenol type epoxy resin, a diaminodiphenyl methane type epoxy resin, a phenol novolac type epoxy resin, an ortho-cresol type epoxy resin, a bisphenol A novolac resin, etc. The curing agent may be mentioned a primary amine, a secondary amine, a phenol resin (for example, a phenol-novolac resin), an acid anhydride, etc. The curing accelerator may be mentioned an imidazole compound (for example, 2-methylimidazole), a tertiary amine, etc. The inorganic filler may be mentioned crystalline silica, amorphous silica, alumina, silicon nitride, aluminum nitride, etc. It is also preferred that a contained ratio of the epoxy resin is preferably 5 to 40% by mass based on 100% by mass of the above-mentioned mixture, a contained ratio of the curing agent is preferably 1 to 30% by mass, a contained ratio of the curing accelerator is preferably 0.1 to 3.0% by mass, and a contained ratio of the inorganic filler is preferably 60 to 93% by mass. Next, to the mixture is added the black titanium oxynitride pigment as a filler, to disperse the black titanium oxynitride pigment in the mixture. A contained ratio of the above-mentioned black titanium oxynitride pigment is preferably in the range of 0.1 to 10% by mass based on the total amount of the above-mentioned mixture and the black titanium oxynitride pigment as 100% by mass. The semiconductor-sealing resin compound is thus produced. The amount of emitted α-radiation of the semiconductor-sealing resin compound is preferably 0.01 cph/cm² or less.

Here, the reason why the contained ratio of the epoxy resin based on 100% by mass of the mixture is limited within the range of 5 to 40% by mass is that if it is less than 5% by mass, adhesiveness to the semiconductor device or the substrate is insufficient, while if it exceeds 40% by mass, strength as the sealing material is insufficient. Also, the reason why the contained ratio of the curing agent based on 100% by mass of the mixture is limited within the range of 1 to 30% by mass is that if it is less than 1% by mass, curing of the resin compound becomes insufficient whereby strength of the sealing material is insufficient, while if it exceeds 30% by mass, storage stability of the resin compound before curing is insufficient. Further, the reason why the contained ratio of the curing accelerator based on 100% by mass of the mixture is limited within the range of 0.1 to 3.0% by mass is that if it is less than 0.1% by mass, curing of the resin compound becomes insufficient whereby strength of the sealing material is insufficient, while if it exceeds 3.0% by mass, storage stability of the resin compound before curing is insufficient. Moreover, the reason why the contained ratio of the inorganic filler based on 100% by mass of the mixture is limited within the range of 60 to 93% by mass is that if it is less than 60% by mass, strength as the sealing material is insufficient, while if it exceeds 93% by mass, adhesiveness to the semiconductor device or the substrate is insufficient. Furthermore, the reason why the contained ratio of the black titanium oxynitride pigment based on the total amount of the mixture and the black titanium oxynitride pigment as 100% by mass is limited within the range of 0.1 to 10% by mass is that if it is less than 0.1% by mass, blackness of the sealing material is lowered, while if it exceeds 10% by mass, adhesiveness to the semiconductor device or the substrate is insufficient. Further, the reason why the amount of emitted $\alpha$-radiation of the semiconductor-sealing resin compound is limited to 0.1 cph/cm$^2$ or less is that if it exceeds 0.1 cph/cm$^2$, there is a fear of causing soft error when a semiconductor is sealed by using the semiconductor-sealing resin compound.

To the semiconductor-sealing resin compound containing these respective components, if necessary, an additive such as a silicone type plasticizer for achieving low elastic modulus, toughness and high moisture resistance, etc. , of the sealing material, a releasing agent for easily separating the molded product from the mold, a coupling agent for improving wetting property or adhesiveness between the resin component and the filler, a flame retardant and an auxiliary flame retardant for imparting flame retardancy, etc., may be optionally added.

When a semiconductor device is sealed by using the thus produced semiconductor-sealing resin compound containing the black titanium oxynitride pigment, the amount of emitted $\alpha$-radiation in the black titanium oxynitride pigment is as little as 0.1 cph/cm$^2$ or less, so that occurrence of soft error which is malfunction of the above-mentioned semiconductor device by $\alpha$ radiation can be suppressed. Also, the black titanium oxynitride pigment contained in the above-mentioned sealing material has high electric insulation and high shielding property of the $\alpha$ radiation, so that even when the wiring pitch of the semiconductor device is narrow, the black titanium oxynitride pigment in the sealing material does not short-circuit the wirings.

EXAMPLES

Next, Examples of the present invention are explained in detail with Comparative examples.

<Example 1>

First, titanium chloride is treated by the distillation method (an impurity decreasing method) in the temperature range of 130 to 140°C to decrease a uranium content and a thorium content in the titanium chloride, respectively. Then, 45 mol of isopropanol (an alcohol) was added to 10 mol of the above-mentioned distilled titanium chloride to react the titanium chloride with isopropanol (an alcohol) to form titanium tetraisopropoxide (titanium alkoxide). Then, titanium tetraisopropoxide was distilled by the reduced-pressure distillation method (a temperature of 130 to 150°C and a pressure of 10 to 20 Pa) for 5 hours to decrease the uranium content and the thorium content in the titanium tetraisopropoxide, respectively. Next, the above-mentioned distilled titanium tetraisopropoxide was hydrolyzed to form a white titanium oxide pigment (TiO$_2$). Then, the above-mentioned white titanium oxide pigment (TiO$_2$) was reduced by an ammonia gas with a flow amount of 10 liter/min for 10 hours to obtain a black titanium oxynitride pigment. Thereafter, ethanol was added to the black titanium oxynitride pigment as an alcohol to disperse the black titanium oxynitride pigment in ethanol, and the pigment was wet-pulverized by a bead mill to obtain a dispersion of the black titanium oxynitride pigment having an average primary particle size of 60 nm. The black titanium oxynitride pigment is represented by the chemical formula: TiN$_X$O$_Y$ (provided that X=0.9 and Y=0.3). Further, the above-mentioned dispersion was separated into a solid and a liquid, and the solid was dried to obtain a black titanium oxynitride pigment. This black titanium oxynitride pigment was made Example 1.

<Example 2>

A black titanium oxynitride pigment was obtained by reducing the white titanium oxide pigment (TiO$_2$) used in Example 1 with an ammonia gas, and the flow amount of the ammonia gas at the reduction and the reaction time were each made a half of Example. Ethanol was added to the black titanium oxynitride pigment as an alcohol to disperse the black titanium oxynitride pigment in ethanol, and the pigment was wet-pulverized by a bead mill to obtain a dispersion of the black titanium oxynitride pigment having an average primary particle size of 140 nm. The black titanium oxynitride pigment is represented by the chemical formula: $TiN_XO_Y$ (provided that X=0.2 and Y=0.8). Further, the above-mentioned dispersion was separated into a solid and a liquid, and the solid was dried to obtain a black titanium oxynitride pigment. This black titanium oxynitride pigment was made Example 2.

<Example 3>

A black titanium oxynitride pigment was obtained in the same manner as in Example 1 except for changing the temperature at the time of distillation under reduced pressure of the titanium tetraisopropoxide to 180°C. This black titanium oxynitride pigment was made Example 3.

<Example 4>

A black titanium oxynitride pigment was obtained in the same manner as in Example 1 except for subjecting to wet pulverization by a bead mill by dispersing the black titanium oxynitride pigment in ethanol, and subjecting the obtained slurry to levigation classification (which is classification of recovering a supernatant containing fine particles after naturally precipitating coarse particles by allowing to stand for 3 days, to obtain a black titanium oxynitride pigment having an average primary particle size of 15 nm. This black titanium oxynitride pigment was made

Example 4.

<Example 5>

A black titanium oxynitride pigment was obtained in the same manner as in Example 1 except for subjecting to wet pulverization by a bead mill by dispersing the black titanium oxynitride pigment in ethanol, and subjecting the obtained slurry to levigation classification (which is classification of recovering a supernatant containing fine particles after naturally precipitating coarse particles by allowing to stand for 3 days) to obtain a black titanium oxynitride pigment having an average primary particle size of 10 nm. This black titanium oxynitride pigment was made Example 5.

<Example 6>

A black titanium oxynitride pigment was obtained in the same manner as in Example 2 except for obtaining a dispersion of a black titanium oxynitride pigment having an average primary particle size of 150 nm by dispersing the black titanium oxynitride pigment in ethanol, and subjecting to wet-pulverization by a bead mill. This black titanium oxynitride pigment was made Example 6.

<Comparative example 1>

A commercially available titanium oxide pigment (anatase type, BET specific surface area: 8 $m^2$/g) was reduced by an ammonia gas under the same conditions as those of Example 1 to obtain a black titanium oxynitride pigment. This black titanium oxynitride pigment was made Comparative example 1.

<Comparative example 2>

A black titanium oxynitride pigment was obtained in the same manner as in Example 1 except for the titanium tetraisopropoxide (titanium alkoxide) was not subjected to the reduced-pressure distillation method. This black titanium oxynitride pigment was made Comparative example 2.

<Comparative test 1 and evaluation>

With regard to the black titanium oxynitride pigments of Examples 1 to 6, Comparative examples 1 and Comparative example 2 , a BET specific surface area, an L* value, a uranium content, a thorium content, an amount of emitted α radiation and tinting strength were measured, respectively. The BET specific surface area of the black titanium oxynitride pigment was measured by using a specific surface area measurement device (Type: SA1100) manufactured by SIBATA SCIENTIFIC TECHNOLOGY, LTD. In addition, the lightness index L* value of the black titanium oxynitride pigment was obtained by using a spectrophotometer (Type: SE2000) manufactured by NIPPON DENSHOKU INDUSTRIES Co., LTD. Also, the uranium content and the thorium content of the black titanium oxynitride pigment were obtained by ICP-MS (Inductively Coupled Plasma-Mass Spectrometry). More specifically, by using ICP (Inductively Coupled Plasma) as an excitation source, excited ions are directly introduced into a mass spectrometer to obtain the uranium content and the thorium content of the black titanium oxynitride pigment. Further, the amount of emitted $\alpha$ radiation was measured by using an $\alpha$ radiation measurement device (Model number: SSB, manufactured by EG&G ORTEC Inc.). Further, the tinting strength of the black titanium oxynitride pigment was measured by using a spectrophotometer (Type: SE2000) manufactured by NIPPON DENSHOKU INDUSTRIES Co., LTD., with regard to a mixed powder in which the black titanium oxynitride pigment and the white titanium oxide pigment had been mixed with a mass ratio of 5:95. And the tinting strength (L* value) of 50 or less was judged as "excellent" and the tinting strength of 60 or less was judged as "good".

On the other hand, semiconductor-sealing resin compounds were each produced by using the black titanium oxynitride pigments of Examples 1 to 6, Comparative example 1 and Comparative example 2, and semiconductors were each sealed by using these resin compounds. More specifically, first, 9% by mass of a biphenyl type epoxy resin (an epoxy resin), 3% by mass of a phenol-novolac resin curing agent (a curing agent), 0.2% by mass of 2-methylimidazole (a curing accelerator) and 77.8% by mass of amorphous silica (an inorganic filler) were mixed to prepare a mixture. Next, 10% by mass of the black titanium oxynitride pigment was added to 100% by mass in a total amount of the mixture and the above-mentioned black titanium oxynitride pigment to produce semiconductor-sealing resin compounds, respectively. Further, these semiconductor-sealing resin compounds were molded to a predetermined shape and heated to 200°C to prepare a molded product, respectively. These molded products were made sealing materials of Examples 1 to 3, Comparative example 1 and Comparative example 2, and electric insulation, blackness and the amount of emitted $\alpha$ radiation of these sealing materials were each measured. The electric insulation of the above-mentioned sealing materials was measured by a resin-sealed type semiconductor device. The sample in which no leakage current had been found was regarded as good, and the sample in which leakage current had been found was regarded as bad. The blackness of the above-mentioned sealing materials was measured by a spectrophotometer. The sample of which the L* value had been 30 or less was regarded as good, and the sample of which the L* value had exceeded 30 was regarded as insufficient. Here, the reason why the standard value (the upper limit value of the range of good) of the L* value of the black titanium oxynitride powder is 14, but the standard value (the upper limit value of the range of good) of the L* value of the sealing material is large as 30, is that the content of the black titanium oxynitride powder in the sealing material is low as 10% by mass. Further, the amount of emitted $\alpha$ radiation of the above-mentioned sealing material was measured by using an $\alpha$ radiation measurement device (Model number: SSB, manufactured by EG&G ORTEC Inc.). These results are shown in Table 1 with the uranium content and the thorium content immediately after distillation of the titanium chloride which is a starting material of Examples 1 to 6 and Comparative example 2. The contents of uranium and thorium in the titanium chloride of Table 1 are contents thereof in the titanium chloride after the treatment by the impurity decreasing method.

Table 1

| | Titanium chloride | | Black titanium oxynitride pigment | | | | | | | | | Sealing material |
|---|---|---|---|---|---|---|---|---|---|---|---|---|
| | Uranium ppb by mass | Thorium ppb by mass | Average primary particle size (nm) | BET specific surface area m²/g | L* value | Uranium ppb by mass | Thorium ppb by mass | Amount of emitted α radiation cph/cm² | Tinting strength | Electric insulation | Blackness | Amount of emitted α radiation cph/cm² |
| Example 1 | 9 | 48 | 60 | 19.0 | 10 | 1 or less | 5 or less | 0.02 | Excellent | Good | Good | 0.01 or less |
| Example 2 | 9 | 48 | 140 | 10.0 | 14 | 1 or less | 5 or less | 0.03 | Excellent | Good | Good | 0.01 or less |
| Example 3 | 10 | 50 | 60 | 18.0 | 11 | 1 or less | 5 or les s | 0.1 | Excellent | Good | Good | 0.01 or less |
| Example 4 | 9 | 48 | 15 | 80.0 | 8 | 1 or less | 5 or less | 0.02 | Excellent | Good | Good | 0.01 or less |
| Example 5 | 10 | 50 | 10 | 120.0 | 7 | 1 or less | 5 or less | 0.05 | Good | Good | Good | 0.01 or less |
| Example 6 | 9 | 48 | 150 | 10.0 | 14 | 1 or less | 5 or less | 0.02 | Good | Good | Good | 0.01 or less |
| C.E. 1 | --- | --- | 60 | 16.9 | 10 | 100 | 300 | 1.5 | Excellent | Good | Good | 0.15 |
| C.E. 2 | 9 | 42 | 60 | 17.0 | 12 | 9 | 47 | 0.8 | Excellent | Good | Good | 0.09 |

C.E.: Comparative Example

As can be seen from Table 1, in the commercially available titanium oxide pigment of Comparative example 1, the amount of emitted $\alpha$-radiation was large as 1.5 cph/cm$^2$ than the standard value of 0.1 cph/cm$^2$ disclosed in Patent Document 2. Also, in the black titanium oxynitride pigment of Comparative example 2 which used titanium chloride but titanium tetraisopropoxide (titanium alkoxide) obtained by subjecting to alcohol-substitution of titanium chloride had not been distilled under reduced pressure, the amount of emitted $\alpha$-radiation was still large as 0.8 cph/cm$^2$. To the contrary, in the black titanium oxynitride pigments of Examples 1 to 6 in which titanium tetraisopropoxides (titanium alkoxide) obtained by subjecting to alcohol-substitution of titanium chloride had been distilled under reduced pressure, the amount of emitted $\alpha$-radiations became 0.02 to 0.1 cph/cm$^2$, which were not more than the standard value of 0.1 cph/cm$^2$ disclosed in Patent Document 2. Further, in the sealing material using the black titanium oxynitride pigment of Comparative example 1 in which the commercially available titanium oxide pigment had been used, the amount of emitted $\alpha$-radiation was large as 0.15 cph/cm$^2$. In the sealing material using the black titanium oxynitride pigment of Comparative example 2 in which the titanium tetraisopropoxide (titanium alkoxide) obtained by subjecting to alcohol-substitution of titanium chloride had not been distilled under reduced pressure whereas titanium chloride had been used, the amount of emitted $\alpha$-radiation was still large as 0.09 cph/cm$^2$. To the contrary, in the sealing materials using the black titanium oxynitride pigments of Examples 1 to 6 in which titanium tetraisopropoxide (titanium alkoxide) obtained by subjecting to alcohol-substitution of titanium chloride had been distilled under reduced pressure, the amount of emitted $\alpha$-radiation was extremely little as 0.01 cph/cm$^2$ or less. As a result, it could be considered that in the sealing materials using the black titanium oxynitride pigments of Comparative examples 1 and 2, there was a fear of causing soft error, but in the sealing materials using the black titanium oxynitride pigments of Examples 1 to 6, the possibility of causing soft error was extremely low. Moreover, in Example 5 in which the average primary particle size of the black titanium oxynitride pigment was relatively little as 10 nm, the tinting strength was "good", and in Example 6 in which the average primary particle size of the black titanium oxynitride pigment was relatively large as 150 nm, the tinting strength was "good", while in Examples 1 to 4 in which the average primary particle size of the black titanium oxynitride pigment was in the preferred range of 15 to 140 nm, the tinting strength was "excellent".

INDUSTRIAL APPLICABILITY

The black titanium oxynitride pigment of the present invention can be utilized as a filler for a sealing material required to have high electric insulation, which is a filler to be dispersed in a resin compound of a sealing material for sealing a semiconductor device, such as a filler for coloring a sealing material to black color for concealing inside thereof, a filler for subjecting to laser mark for printing a letter of a lot number, etc. , to a sealing material, and a filler to be dispersed in a sealing material for sealing an on-vehicle power semiconductor device through which a large current is to be flowed. In addition, since the black titanium oxynitride pigment of the present invention has high electric insulation, it can be utilized as a coloring material for an electronic display element, for example, a resin black matrix of a liquid crystal color filter, and a black film required to have blackness and electric insulation in a black color seal material, a rib material, a flexible printed board, etc.

**Claims**

1. A black titanium oxynitride pigment having an amount of emitted $\alpha$ radiation of 0.1 cph/cm$^2$ or less.

2. The black titanium oxynitride pigment according to claim 1, wherein a uranium content is 1 ppb by mass or less and a thorium content is 5 ppb by mass or less.

3. The black titanium oxynitride pigment according to claim 1 or 2, wherein a lightness index L* value in a CIE 1976 L*a*b* color space (light source C for measurement: color temperature 6774K) is 14 or less.

4. The black titanium oxynitride pigment according to any one of claims 1 to 3, wherein a BET specific surface area is 10 m$^2$/g or more.

5. The black titanium oxynitride pigment according to any one of claims 1 to 4, wherein an average primary particle size is 15 nm to 140 nm.

6. A method of producing a black titanium oxynitride pigment comprising the steps of:

distilling titanium chloride to decrease a uranium content and a thorium content in the titanium chloride to 10 ppb by mass or less and 50 ppb by mass or less, respectively;

reacting the distilled titanium chloride with an alcohol to form titanium alkoxide;
distilling the titanium alkoxide to decrease a uranium content and a thorium content in the titanium alkoxide to 1 ppb by mass or less and 5 ppb by mass or less, respectively;
hydrolyzing the distilled titanium alkoxide to form a white titanium oxide pigment; and
reducing the white titanium oxide pigment with an ammonia gas to obtain a black titanium oxynitride pigment having a uranium content and a thorium content of 1 ppb by mass or less and 5 ppb by mass or less, respectively.

7. A semiconductor-sealing resin compound which comprises the black titanium oxynitride pigment according to any one of claims 1 to 5 being dispersed in a mixture of an epoxy resin, a curing agent, a curing accelerator and an inorganic filler.

## INTERNATIONAL SEARCH REPORT

| International application No. |
|---|
| PCT/JP2015/058695 |

A. CLASSIFICATION OF SUBJECT MATTER
*C01G23/04*(2006.01)i, *C08K3/00*(2006.01)i, *C08K3/28*(2006.01)i, *C08L63/00* (2006.01)i, *H01L23/29*(2006.01)i, *H01L23/31*(2006.01)i

According to International Patent Classification (IPC) or to both national classification and IPC

B. FIELDS SEARCHED

Minimum documentation searched (classification system followed by classification symbols)
C01G23/04, C08K3/00, C08K3/28, C08L63/00, H01L23/29, H01L23/31

Documentation searched other than minimum documentation to the extent that such documents are included in the fields searched
Jitsuyo Shinan Koho          1922-1996   Jitsuyo Shinan Toroku Koho   1996-2015
Kokai Jitsuyo Shinan Koho    1971-2015   Toroku Jitsuyo Shinan Koho   1994-2015

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2006-206891 A  (Ishihara Sangyo Kaisha, Ltd.),<br>10 August 2006 (10.08.2006),<br>claims; paragraphs [0002] to [0040]<br>& US 2008/0017835 A1    & WO 2006/070795 A1<br>& KR 10-2007-0103407 A   & CN 101090866 A<br>& KR 10-1240091 B | 1-5,7<br>6 |
| Y<br>A | JP 9-137269 A  (Vacuum Metallurgical Co., Ltd.),<br>27 May 1997 (27.05.1997),<br>claims; paragraph [0006]<br>(Family: none) | 1-5,7<br>6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 03 June 2015 (03.06.15) | 23 June 2015 (23.06.15) |

| Name and mailing address of the ISA/<br>Japan Patent Office<br>3-4-3,Kasumigaseki,Chiyoda-ku,<br>Tokyo 100-8915,Japan | Authorized officer |
|---|---|
| | Telephone No. |

Form PCT/ISA/210 (second sheet) (July 2009)

**INTERNATIONAL SEARCH REPORT**

<table>
<tr><td>International application No.</td></tr>
<tr><td>PCT/JP2015/058695</td></tr>
</table>

C (Continuation).    DOCUMENTS CONSIDERED TO BE RELEVANT

| Category* | Citation of document, with indication, where appropriate, of the relevant passages | Relevant to claim No. |
|---|---|---|
| Y<br>A | KR 10-2004-0008461 A  (KUMKANG KOREA CHEM CO.,<br>LTD.),<br>31 January 2004 (31.01.2004),<br>pages 2 to 5<br>(Family: none) | 7<br>1-6 |
| Y<br>A | KR 10-2011-0078819 A  (CHEIL IND INC.),<br>07 July 2011 (07.07.2011),<br>pages 3 to 12<br>(Family: none) | 7<br>1-6 |
| Y<br>A | JP 2011-228499 A  (Nitto Denko Corp.),<br>10 November 2011 (10.11.2011),<br>paragraphs [0029] to [0066]<br>& US 2013/0095639 A1    & WO 2011/132648 A<br>& WO 2011/132648 A1    & TW 201203425 A<br>& CN 102947930 A        & KR 10-2013-0056863 A | 7<br>1-6 |
| Y<br>A | JP 2012-33555 A  (Nitto Denko Corp.),<br>16 February 2012 (16.02.2012),<br>paragraphs [0028] to [0084]<br>& US 2012/0025404 A1    & CN 102382586 A<br>& KR 10-2012-0022579 A  & TW 201224101 A | 7<br>1-6 |

Form PCT/ISA/210 (continuation of second sheet) (July 2009)

**REFERENCES CITED IN THE DESCRIPTION**

**Patent documents cited in the description**

- JP 064922 A
- JP 2014064922 A
- JP 2005206621 A
- JP HEI9137269 A